Europäisches Patentamt

European Patent Office

Office européen des brevets

(19)

(11) Numéro de publication : **0 002 407**
**B1**

(12)

# FASCICULE DE BREVET EUROPÉEN

(45) Date de publication du fascicule du brevet :
08.07.81

(21) Numéro de dépôt : **78400191.9**

(22) Date de dépôt : **17.11.78**

(51) Int. Cl.³ : **H 01 J 37/147**, H 01 J 37/08,
H 01 J 27/02

(54) Electrode d'extraction mobile pour source d'ions.

(30) Priorité : 28.11.77 FR 7735758

(43) Date de publication de la demande :
13.06.79 (Bulletin 79/12)

(45) Mention de la délivrance du brevet :
08.07.81 Bulletin 81/27

(84) Etats contractants désignés :
CH DE GB NL

(56) Documents cités :
GB - A - 616 024
US - A - 3 619 062

(73) Titulaire : ANVAR Agence Nationale de Valorisation
de la Recherche
13, rue Madeleine Michelis
F-92522 Neuilly-sur-Seine (FR)

(72) Inventeur : Camplan, Jean
37, Boulevard Garibaldi
F-75015 Paris (FR)
Inventeur : Chaumont, Jacques
4, Square Arago
F-78330 Fontenay le Fleury (FR)
Inventeur : Meunier, Robert
9, Chemin à Dieu
F-78830 Bonnelles (FR)

(74) Mandataire : Mongredien, André et al
c/o Brevatome 25, rue de Ponthieu
F-75008 Paris (FR)

Imprimerie Jouve, 17, rue du Louvre, 75001 Paris, France

Electrode d'extraction mobile pour source d'ions

La présente invention a pour objet une électrode d'extraction mobile pour source d'ions. Elle trouve une application dans la réalisation d'implanteurs ioniques destinés notamment à la fabrication de semiconducteurs.

On sait que dans les implanteurs ioniques et les séparateurs d'isotopes, une électrode d'extraction est disposée devant la source d'ions pour commander la forme et la direction du faisceau d'ions. Cette électrode est constituée par un écran percé d'une ouverture, l'écran étant porté à un potentiel négatif par rapport à la source.

La forme du faisceau d'ions est en grande partie définie par la différence de potentiel et la distance entre l'écran de l'électrode et la source. En effet, si l'électrode d'extraction est très proche de la fente de sortie de la source d'ions, ou si sa tension de polarisation est très élevée, l'électrode repousse la limite du plasma à l'intérieur de la chambre d'ionisation qui présente alors, au voisinage de la fente de sortie un ménisque de forme concave. Dans ces conditions, les ions qui s'échappent de la source se répartissent à l'intérieur d'un faisceau convergent qui, dans la plupart des cas, ne donne pas satisfaction.

Si l'électrode d'extraction est éloignée de la source ou si sa tension de polarisation est faible, la limite du plasma n'est plus repoussée à l'intérieur de la chambre d'ionisation et le plasma présente, au voisinage de la fente de sortie, un ménisque de forme convexe. Les ions émis par la source sont alors répartis dans un faisceau divergent qui correspond en général à la forme souhaitée.

En principe, les caractéristiques du faisceau d'ions émis par une source d'ions associée à une électrode d'extraction ne dépendent pas seulement de la tension de polarisation de cette dernière et de sa distance à la source. Un grand nombre de paramètres interviennent dans cette détermination, en particulier la densité du plasma, la masse des ions, la largeur de la fente de la source, etc... Mais, la plupart de ces paramètres sont fixés par construction. Quant à la tension de polarisation, elle intervient par sa racine carrée, ce qui réduit son influence. Finalement, le seul paramètre sensible sur lequel on puisse agir dans la pratique, est la distance qui sépare l'électrode d'extraction et la source d'ions.

Le problème s'est donc posé de réaliser, dans les implanteurs ioniques, un couple source d'ions-électrode d'extraction, dont les positions relatives soient commandables de l'extérieur de l'enceinte à vide où elles sont placées. De préférence, cette électrode doit pouvoir être translatée dans une direction perpendiculaire à son plan et être orientée autour d'au moins un axe contenu dans son plan.

Or, pour résoudre ce problème, on se heurte à deux sortes de difficultés. D'une part, les moyens de déplacement de l'électrode sont placés sous vide et, d'autre part, ils sont disposés à proximité d'une source de chaleur (la source d'ions). Ces moyens sont donc inévitablement soumis à des déformations et contraintes qui sont de nature à provoquer des blocages du mécanisme de déplacement. C'est ainsi, notamment, que les systèmes de translation à glissières ne conviennent pas du tout dans cette application, comme étant sujets à de trop nombreux grippages et blocages.

L'invention a justement pour but de fournir une électrode d'extraction qui ne présente pas ces inconvénients, en ce sens que les frottements sont quasi-inexistants dans les parties chaudes du couple source-électrode et sont limités aux parties relativement froides, et qu'elle présente un minimum de pièces mécaniques en mouvement sous vide.

De façon précise, l'invention a pour objet une électrode d'extraction mobile pour source d'ions, consistant en un écran métallique percé d'une ouverture et destiné à être placé dans une enceinte à vide devant une source d'ions, l'écran devant être porté, par rapport à la source, à une tension négative, cette électrode étant caractérisée en ce qu'elle est munie de moyens mécaniques pour commander de l'extérieur de l'enceinte son déplacement ces moyens comprenant deux systèmes aptes à déplacer indépendamment deux côtés latéraux à l'écran, chacun de ces systèmes comportant :

— un parallélogramme déformable constitué par deux bras parallèles articulés à l'une de leurs extrémités sur une pièce soutenant l'un des côtés de l'écran et à l'autre de leurs extrémités sur une pièce coulissant sur une colonne de guidage parallèle audit côté ;

— un moyen apte à commander la déformation dudit parallélogramme et comprenant : une biellette dont l'extrémité est articulée sur l'un des bras et qui est montée sur une roue dentée qui engrène sur une vis sans fin reliée à une tige traversant ladite enceinte.

De préférence, l'ensemble constitué par la biellette, la roue dentée et la vis sans fin, est monté sur un chariot qui peut coulisser sur la colonne de guidage, un troisième système de déplacement accessible de l'extérieur étant prévu pour commander le déplacement dudit chariot sur la colonne de guidage.

Des modes particuliers de réalisation seront décrits à titre d'exemples, en référence aux dessins annexés sur lesquels :

— la figure 1 est une vue de face de l'électrode, objet de l'invention, illustrant les deux systèmes de déplacement des côtés latéraux et le système de translation du chariot ;

— la figure 2 est une vue de côté illustrant un détail de réalisation de l'un des deux systèmes à parallélogramme déformable ;

— la figure 3 est une vue de dessus illustrant le mouvement de basculement de l'écran.

Pour fixer les sens de déplacement des différents organes, on se référera, dans la description qui va suivre, à un trièdre trirectangle oxyz, l'écran étant disposé dans un plan parallèle à yoz.

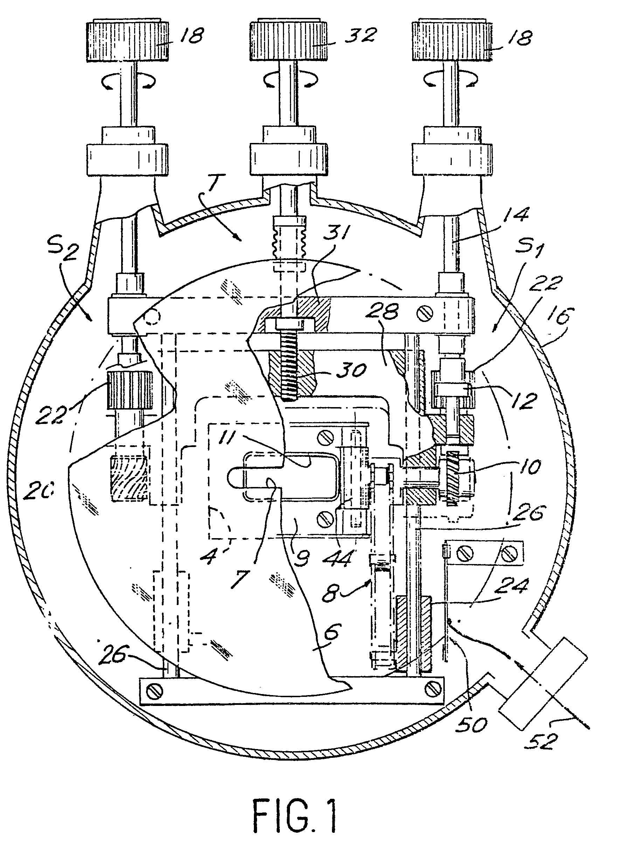

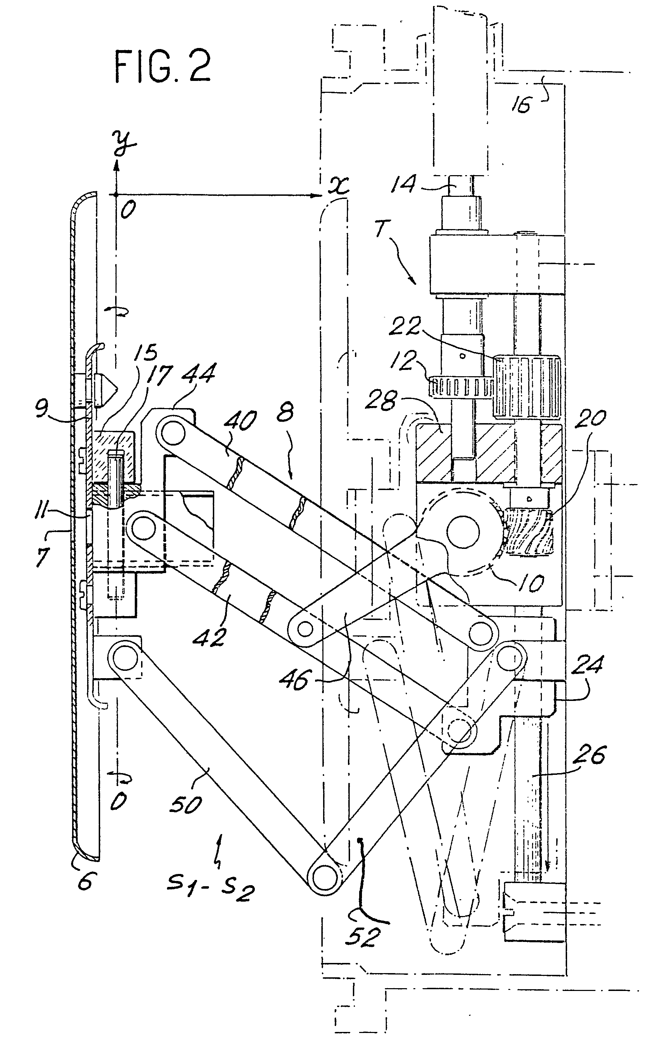

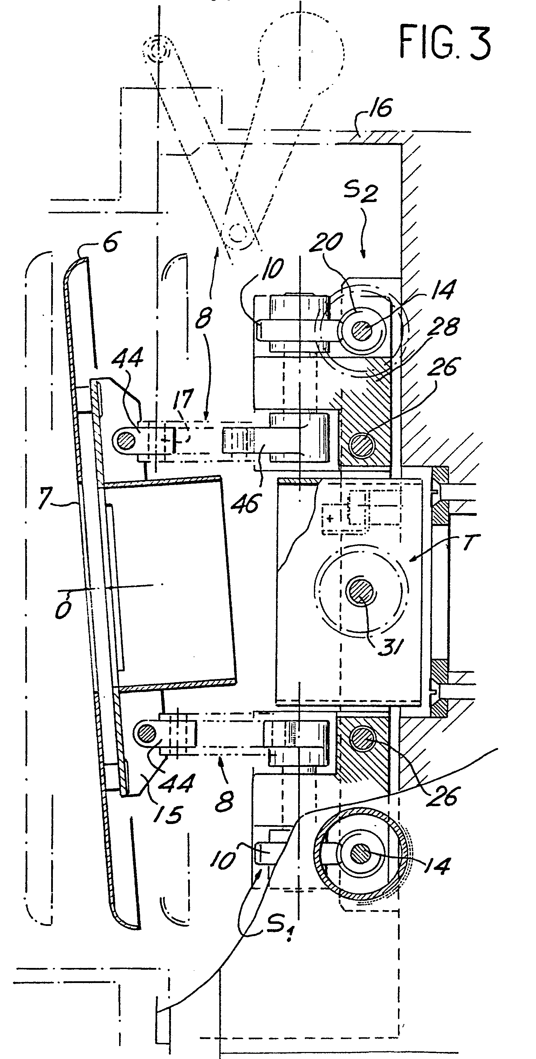

Chacune des figures correspond à une vue selon l'un des trois axes de ce trièdre : la figure 1 correspond à l'axe ox, la figure 2 à l'axe oz et la figure 3 à l'axe oy.

Sur la figure 1, les moyens représentés comprennent, d'une part, deux systèmes latéraux de déplacement $S_1$ et $S_2$ et un système central de translation. Les systèmes $S_1$ et $S_2$ sont appliqués en des points 2 et 4 d'un écran 6 percé d'une ouverture 7 dont l'axe principal est parallèle à oz. Derrière cet écran est fixé un carénage 9 percé d'une ouverture 11.

Pour alléger la figure, la partie droite ne retient essentiellement que les moyens situés à la partie supérieure de l'ensemble, à savoir un parallélogramme déformable 8 vu sur le côté, une roue dentée 10, un pignon 12 relié à une tige de commande 14 accessible de l'extérieur de l'enceinte 16 et terminée par un bouton 18 ; la partie gauche retient essentiellement les organes situés à la partie inférieure de l'ensemble, à savoir, une vis sans fin 20 (dans laquelle engrène la roue 10), un pignon 22 (dans lequel engrène le pignon 12). Ces organes apparaîtront plus en détail sur la figure 2.

La figure 1 montre également comment le système à parallélogramme 8 est relié à une pièce 24 qui coulisse sur une colonne de guidage 26, sur laquelle coulisse également un chariot 28 supportant la roue dentée 10 et le pignon 22. Ce chariot peut être déplacé par le système central T par action sur la vis 30 reliée à une tige 31 accessible de l'extérieur de l'enceinte 16 et terminée par un bouton 32. Les moyens représentés sur la partie droite de la figure sont représentés dans une position légèrement plus basse que le moyen de la partie gauche pour illustrer précisément ce déplacement du chariot.

Le système $S_1$ et notamment les moyens essentiels constituant le parallélogramme déformable, sont représentés sur la vue de côté de la figure 2. Ces moyens comprennent deux bras parallèles 40 et 42 articulés sur une pièce 44 reliée à l'écran 6 et sur la pièce 24 déjà mentionnée, qui coulisse le long de la colonne de guidage 26. La pièce 44 est reliée à une pièce 15 par des axes 17. La pièce 15 supporte le carénage 9. Une biellette 46 a son extrémité reliée au bras 42 et elle est solidaire de la roue dentée 10 déjà mentionnée, laquelle peut être commandée en rotation par la vis sans fin 20 solidaire du pignon 22 dans lequel engrène le pignon 12 fixé à la tige de commande 14.

Le rôle du carénage 9, solidaire de la pièce 15, est double : réduire la tension nécessaire pour créer la barrière de potentiel destinée à retenir les ions du faisceau et protéger le mécanisme contre les vapeurs provenant de la source et qui, à la longue, l'encrassent.

Lorsque l'opérateur agit sur la tige 14, les organes mentionnés provoquent la déformation du parallélogramme, ce qui a pour effet de déplacer l'écran-électrode vers l'avant ou vers l'arrière, c'est-à-dire selon la direction ox. En trait mixte est représentée la position extrême des pièces lorsque le parallélogramme est complètement replié, l'écran-électrode occupant alors une position en retrait.

Sur la figure 2, est représenté, en outre, un bras articulé 50 permettant de réaliser la liaison électrique entre l'écran-électrode 6 et une connexion 52 d'amenée de tension.

La figure 2 montre également comment la transmission du mouvement à la biellette 46 peut s'effectuer par la tige 14 en dépit de son déplacement possible par rapport à cette même tige. Ceci est rendu possible grâce au jeu de pignons 22 et 12, le premier étant solidaire du chariot 28 et le second de la tige 14. Lorsque le chariot 28 coulisse le long de la colonne de guidage 26, le pignon 22 continue à engrener dans le pignon 12 car sa longueur est prévue pour être au moins égale à l'amplitude de la translation souhaitée.

La figure 3 est une vue de dessus des moyens de l'invention, qui illustre le pivotement de l'écran autour de l'axe oy que l'on obtient lorsque les deux systèmes $S_1$ et $S_2$ sont commandés de manière différente. Ce pivotement s'effectue grâce aux axes d'articulation 17. Dans la position représentée, le parallélogramme du système $S_1$ est davantage replié que celui du système $S_2$. D'autres éléments apparaissent encore sur cette figure, qui ont déjà été représentés sur les précédentes figures et qui, pour cette raison, portent les mêmes références.

On notera que, dans le mécanisme qui vient d'être décrit, la partie femelle des pièces est toujours plus chaude (parce que plus liée à la source de chaleur) que la partie mâle, de sorte que l'échauffement de ces pièces ne risque pas de faire gripper ou coincer le mécanisme.

**Revendications**

1. Electrode d'extraction mobile pour source d'ions, consistant en un écran métallique percé d'une ouverture et destiné à être placé dans une enceinte à vide devant une source d'ions, l'écran devant être porté, par rapport à la source, à une tension négative, caractérisée en ce qu'elle est munie de moyens mécaniques (18, 32) pour commander de l'extérieur de l'enceinte son déplacement, ces moyens comprenant deux systèmes ($S_1$, $S_2$) aptes à déplacer indépendamment deux côtés latéraux de l'écran, chacun de ces systèmes comportant :

— un parallélogramme déformable (8) constitué par deux bras parallèles (40, 42) articulés à l'une de leurs extrémités sur une pièce (15) soutenant l'un des côtés de l'écran (6) et à l'autre de leurs extrémités sur une pièce (24) coulissant sur une colonne de guidage (26) parallèle audit côté ;

— un moyen apte à commander la déformation dudit parallélogramme et comprenant : une biellette (46) dont l'extrémité est articulée sur l'un des bras (42) et qui est montée sur une roue dentée (10) qui engrène sur une vis sans fin (20) reliée à une tige traversant l'enceinte (14).

2. Electrode selon la revendication 1, caracté- risée en ce que l'ensemble constitué par la biellette, la roue dentée et la vis sans fin est monté sur un chariot (28) qui peut coulisser sur la colonne de guidage, un troisième système de déplacement (32, T) accessible à l'extérieur étant prévu pour commander le déplacement du chariot sur la colonne de guidage.

3. Electrode selon la revendication 2, caractérisée en ce que la vis sans fin (20) est solidaire d'un pignon (22) dans lequel engrène un autre pignon (12) relié à la tige de commande (14).

### Claims

1. A movable extraction electrode for an ion source, consisting of a metallic screen pierced by an opening and intented to be placed within a vacuum chamber in front of an ion source, said screen being intended to be brought to a negative potential with respect to said source, wherein said electrode is provided with mechanical means (18, 32) for controlling the displacement of the electrode from the exterior of the chamber, said means being constituted by two systems ($S_1$, $S_2$) for displacing two lateral sides of the screen independently and each system aforesaid being constituted by :
— a deformable parallelogram (8) having two parallel arms (40, 42) pivotally attached at one end to a member (15) for supporting one side of the screen (6) and at the other end to a member (24) which is slidably mounted on a guide column (26), said column being parallel to said side ;
— means for controlling the deformation of said parallelogram and comprising : a link-arm (46) pivotally mounted at one end on one of the arms (42) and mounted at the other end on a toothed wheel (10) disposed in meshing engagement with an endless screw (20) coupled to a rod which passes through said chamber (14).

2. An electrode according to claim 1, wherein the assembly consisting of link-arm, toothed wheel and endless screw is mounted on a carriage (28) which is capable of sliding on the guide column, a third displacement system (32, T) which is accessible from the exterior being provided for controlling the displacement of the carriage on the guide column.

3. An electrode according to claim 2, wherein the endless screw (20) is rigidly fixed to a pinion (22) disposed in meshing engagement with another pinion (12) which is coupled to the control rod (14).

### Ansprüche

1. Bewegbare Absaugelektrode für eine Ionenquelle, bestehend aus einer metallischen Scheibe, die mit einer Öffnung durchbrochen ist und in einem Vakuumbehälter als Ionenquelle angeordnet werden soll, wobei die Scheibe gegenüber der Quelle auf eine negative Spannung gebracht werden soll, dadurch gekennzeichnet, dass sie mit einer mechanischen Einrichtung (18, 32) versehen ist zur von aussen her erfolgenden Steuerung ihrer Verschiebung, wobei diese Einrichtung zwei Systeme ($S_1$, $S_2$) aufweist, die unabhängig zwei Seiten der Scheibe verschieben kann, wobei jedes dieser Systeme aufweist :
— ein verformbares Parallelogramm (8) aus zwei parallelen Armen (40, 42), die an einem ihrer Enden an einem eine der Seiten der Scheibe (6) haltenden Teil (15) und am anderen ihrer Enden an einem Teil (24) angelenkt sind, das auf einer zu dieser Seite parallelen Führungssäule (26) gleitet,
— eine Einrichtung, die sich zur Steuerung der Verformung des Parallelogramms eignet und einen Hebel (46) aufweist, dessen Ende an einem (42) der Arme angelenkt und an einem Zahnrad (10) befestigt ist, das mit einem Schneckenrad (20) in Eingriff steht, das mit einer den Behälter (14) durchquerenden Stange verbunden ist.

2. Elektrode nach Anspruch 1, dadurch gekennzeichnet, dass die aus dem Hebel, dem Zahnrad und dem Schneckenrad bestehende Anordnung auf einem Wagen (28) montiert ist, der sich auf der Führungssäule verschieben kann, wobei ein von aussen her zugängliches drittes Verschiebungssystem (32, T) vorgesehen ist zur Steuerung der Verschiebung des Wagens auf der Führungssäule.

3. Elektrode nach Anspruch 2, dadurch gekennzeichnet, dass das Schneckenrad (20) mit einem Zahnrad (22) verbunden ist, in das ein mit der Steuerstange (14) verbundenes weiteres Zahnrad (12) eingreift.

FIG. 1

FIG. 2

0 002 407

0 002 407

FIG. 3